# EUROPEAN PATENT SPECIFICATION

(11) **EP 3 419 174 B1**
(45) Date of publication and mention of the grant of the patent: **03.03.2021**
(21) Application number: 18179181.5
(22) Date of filing: 21.06.2018
(51) Int. Cl.: H03K 17/96, B60K 37/06

(54) **CAPACITIVE TOUCH ASSEMBLY AND CONTROL PANEL**
KAPAZITIVE BERÜHRUNGS-BAUGRUPPE UND BEDIENFELD
ENSEMBLE TACTILE CAPACITIF ET PANNEAU DE COMMANDE

(30) Priority: 21.06.2017 CN 201710475503
(43) Date of publication of application: 26.12.2018
(73) Proprietor: Valeo Comfort and Driving Assistance, 94046 Créteil Cedex (FR)
(72) Inventor: HUANG, Changgui, Shenzhen, Guangdong 518128 (CN); LIU, Min, Shenzhen, Guangdong 518128 (CN); LI, Zhifeng, Shenzhen, Guangdong 518128 (CN); ZHU, Jiping, Shenzhen, Guangdong 518128 (CN)
(74) Representative: Delplanque, Arnaud

(56) References cited:
- EP-A1- 2 408 112
- WO-A1-2006/034993
- WO-A1-2013/098035
- WO-A2-2010/028472
- CN-U- 203 313 148
- JP-A- 2013 105 739

## Description

### BACKGROUND

### Technical Field

The present invention relates to the technical field of control or motor vehicle, and more particularly, to a capacitive touch assembly and a control panel including the capacitive touch assembly.

### Description of the Related Art

Capacitive sensing touch keys are more and more widely used in a control interface of a home appliance. For example, in some control panels of microwave ovens and washing machines, capacitive touch keys are used to replace ordinary mechanical keys as control switches. Compared to the ordinary mechanical key, the capacitive touch key has fewer mechanical parts and is not easy to wear, so it has a longer service life. Moreover, the capacitive touch key generally has a more flat appearance, and the parts of the capacitive touch key can be isolated from the surrounding environment. Thus it will not accumulate dirt at a gap between the key and a key slot as the conventional key does, thereby the appearance is more neat and beautiful. Therefore, the capacitive sensing touch key has the effect that the conventional mechanical key cannot achieve.

Traditionally, in order to realize a sensing touch function, the capacitive sensing touch key is configured in such a way that wires are integrated on a foil, and then the foil is attached to a panel film by gluing, however it needs a special machinery to achieve the attachment of the foil and the panel film. This leads to manufacturing cost increase and process complexity because silver paste line, indium tin oxide (ITO), and/or PEDOT need/needs to be printed on the foil during manufacturing the foil, and these low-impedance conductive materials themselves are high-cost, and a connector is required to connect the foil to a printed circuit board, which also leads to a rise in the cost. In addition, the panel film needs to be attached to the foil by using a special film applicator, and it is necessary to ensure that there is no air bubble between the panel film and the foil during the attaching process, thereby it raises a higher requirement on the process

Another example of known capacitive touch assembly is disclosed in document WO 2006/034993 A1 wherein the capacitive touch assembly comprises a cover plate and a printed circuit board assembly. An elastic conductor is arranged between the printed circuit board and the cover plate.

### SUMMARY

An object of the present invention is to at least partially overcome the drawbacks in the prior art and provide a capacitive touch assembly and a control panel which are cost effective.

Another object of the present invention is to provide a capacitive touch assembly and a control panel which may be manufactured by a simpler manufacturing process.

A further object of the present invention is to provide a capacitive touch assembly and a control panel which have a better tactile impression.

To achieve at least one of the above objects, the technical solutions of the present invention are provided in a capacitive touch assembly according to the appended independent claim 1.

According to a preferred embodiment of the present invention, the elastic conductor is maintained between the cover plate and the printed circuit board assembly in a pre-compressed manner.

According to a preferred embodiment of the present invention, the helical section comprises one end of the elastic conductor, said end of the elastic conductor is configured to tilt toward the bending section, and a portion of the helical section excluding said end is constructed to be in a same plane.

According to a preferred embodiment of the present invention, the portion of the helical section excluding said end has a substantially quadrilateral profile.

According to a preferred embodiment of the present invention, the bending section comprises a fishhook-like structure.

According to a preferred embodiment of the present invention, the printed circuit board assembly comprises a contact hole extending through the printed circuit board assembly.

According to a preferred embodiment of the present invention, the fishhook-like structure is inserted into the contact hole.

According to a preferred embodiment of the present invention, the contact hole is coated with a conductive layer.

According to a preferred embodiment of the present invention, a reinforcing rib is provided in the mounting groove.

According to a preferred embodiment of the present invention, an indicator is provided on the printed circuit board assembly, and the touch key comprises an indicating pattern formed of a light transmitting region.

According to another aspect of the present invention, there is also provided a control panel, comprising the above-described capacitive touch assembly.

According to a preferred embodiment of the present invention, the control panel further comprises a display module.

According to the capacitive touch assembly of the present invention, an elastic conductor is disposed between a cover plate or a cover sheet and a printed circuit board assembly, without any foils, so as to realize a capacitive touch sensing function. The elastic conductor can convert a mechanical touch signal into an electrical signal and transmit it to the printed circuit board assembly, thereby avoiding the need for integrating wires to the foil and the need for connecting the foil to the cover plate by gluing, and significantly reducing material costs and process costs. In addition, since the attachment process of the panel film and the foil is no longer required in the manufacturing process, the process is simple.

Advantageously, the elastic conductor is maintained between the cover plate and the printed circuit board assembly in a pre-compressed manner, which makes the elastic conductor and the printed circuit board assembly are electrically connected with each other at all times, thereby providing sufficient contact reliability. In the present invention, the elastic conductor is configured as a structure with a foot and a crown, specifically, the elastic conductor includes a bending section and a helical section. Through the design of hook-shaped structure of the bending section and a contact hole, the tolerance of manufacturing the elastic conductor may be relaxed. In this case, the elastic conductor can be easily held between the cover plate and the printed circuit board assembly with a certain pre-compression, and sufficient contact between the elastic conductor and the printed circuit board assembly can be ensured. The design of circular helical section expands the contact area and facilitates the transmission of the mechanical touch signal.

Due to the pre-compression of the elastic conductor acting on the cover plate, the user feels a better tactile impression when manipulating touch keys. Further, the same effect as the physical press key can be provided on the touch-sensitive switch, that is, the touch-sensitive switch can be operated in a touch manner, and it can also be pushed down slightly like the physical press key, and by means of elastic restoring force provided by the elastic conductor, it makes the user feel like pressing the physical press key.

In addition, in the capacitive touch assembly of the present invention, the elastic conductor is installed in a mounting groove on a back side of the cover plate, and the elastic conductor is guided, positioned and fixed by a retaining rib in the mounting groove, and the structure of the retaining rib and the structure of the helical section are matched in shape with each other, so that the elastic conductor is firmly mounted and the elastic conductor will not be loosened at any time. The design of the mounting groove and the retaining rib guarantees flatness of a side of the cover plate facing the user, because the pre-compression of the elastic conductor is distributed dispersedly on the retaining rib, and the area of the touch key of the cover plate does not receive excessive force accordingly.

In summary, the capacitive touch assembly and the control panel including the same according to the present invention have better technical effects.

### BRIEF DESCRIPTION OF THE DRAWINGS

Fig. 1 is an exploded view showing an internal structure of a conventional capacitive touch module;
Fig. 2 is a schematic principle diagram of a conventional capacitive touch assembly;
Fig. 3 is an exploded view of a control panel according to an embodiment of the present invention.
Fig. 4 is a front view of a control panel according to an embodiment of the present invention;
Fig. 5 is a cross sectional view taken along line A-A in Fig. 4;
Fig. 6 is a rear view of a cover plate of a capacitive touch assembly according to an embodiment of the present invention, in which an elastic conductor is mounted;
Fig. 7 is a partially enlarged view of Fig. 6;
Fig. 8 is a view corresponding to Fig. 7 in a state where the elastic conductor is not mounted;
Fig. 9 is a view showing an elastic conductor and a printed circuit board assembly to be installed;
Fig. 10 is a view showing an elastic conductor and a printed circuit board assembly which have been installed;
Fig. 11 is a front plan view corresponding to Fig. 10; and
Fig. 12 is a cross sectional view taken along line B-B in Fig. 11.

### DETAILED DESCRIPTION OF PREFERRED EMBODIMENTS

Exemplary embodiments of the present invention will be described in detail below with reference to the accompanying drawings in which the same or similar reference numerals represent the same or similar elements. In addition, in the following detailed description, numerous specific details are set forth in order to facilitate the explanation and provide a thorough understanding of the embodiments of the present disclosure. However, it will be apparent that the embodiment(s) may also be practiced without these specific details. In other cases, well-known structures and devices are schematically illustrated to simplify the drawings.

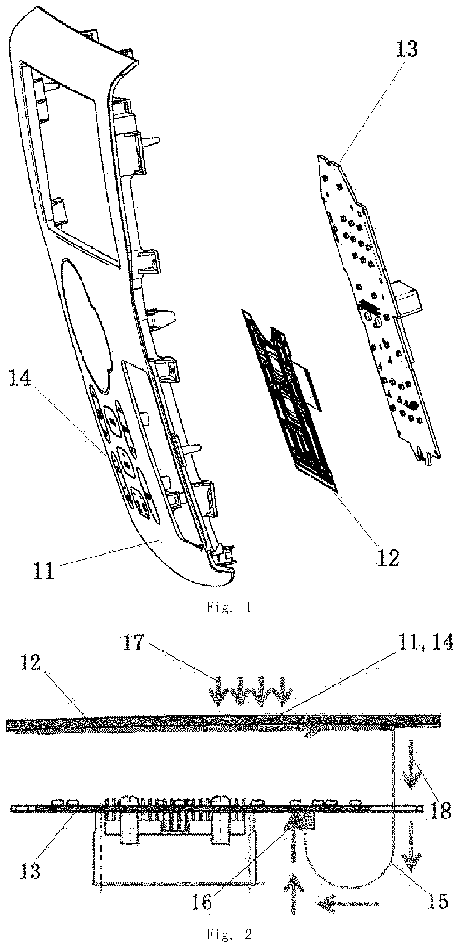

Fig. 1 shows an internal structure of a conventional capacitive touch module; and Fig. 2 is a schematic principle diagram of a conventional capacitive touch assembly. The conventional capacitive touch assembly is described below with reference to Figs. 1-2. As shown in Fig. 1, the capacitive touch assembly includes a foil 12 and a printed circuit board 13. Conductive wires are integrated on the foil 12, the foil 12 and the printed circuit board 13 are connected by a connector, and then a panel 11 with press keys 14 is covered on the foil 12. Conventionally, the foil 12 is attached to a back side of the panel 11 by a transparent double-sided adhesive tape. After the attachment is completed, as shown in Fig. 2, the panel 11 is attached to the foil 12, and a flexible printed circuit 15 of the foil 12 is connected to the printed circuit board 13 through a connector 16. A user's touch action 17 causes capacitance value to change, and the change is input as an electrical signal 18 to the printed circuit board 15. However, the manufacturing process of the capacitive touch assembly described above leads to high manufacturing cost and process complexity because silver paste line, indium tin oxide (ITO), and/or PEDOT need/needs to be printed on the foil during manufacturing the foil, and these low-impedance conductive materials themselves are high-cost, and a connector is required to connect the foil to a printed circuit board, which also leads to a rise in the cost. In addition, the panel film needs to be attached to the foil by using a special film applicator, and it is necessary to ensure that there are no air bubbles between the panel film and the foil during the attaching process, and thereby it raises a higher requirement on the process.

According to a general inventive concept of the present invention, it provides a capacitive touch assembly, comprising a cover plate and a printed circuit board assembly, wherein the capacitive touch assembly further comprises a conductor (for example, a conductive line) located between the cover plate and the printed circuit board assembly and electrically connected to the printed circuit board assembly.

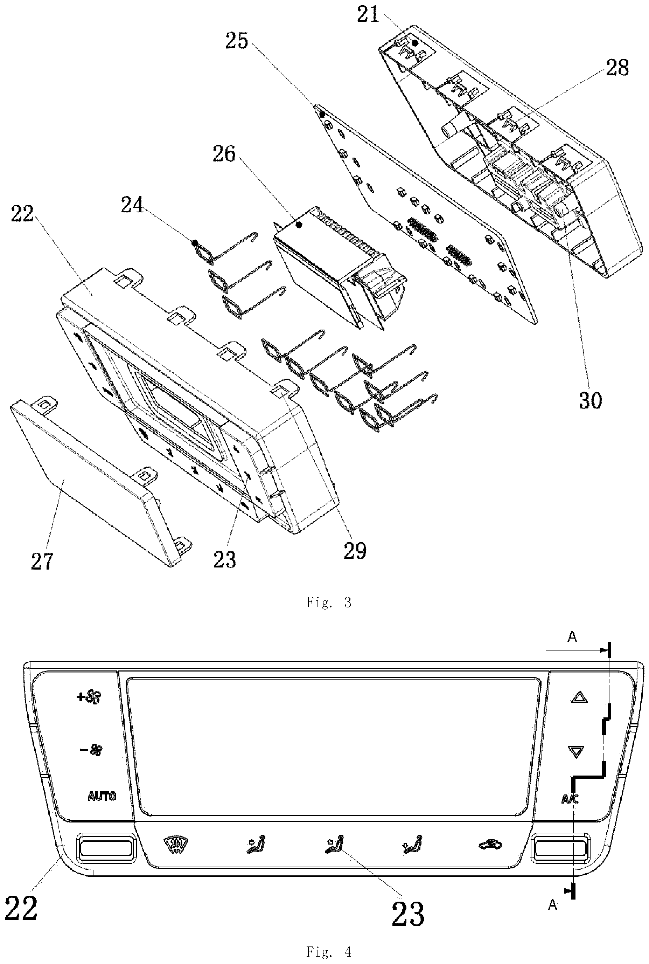

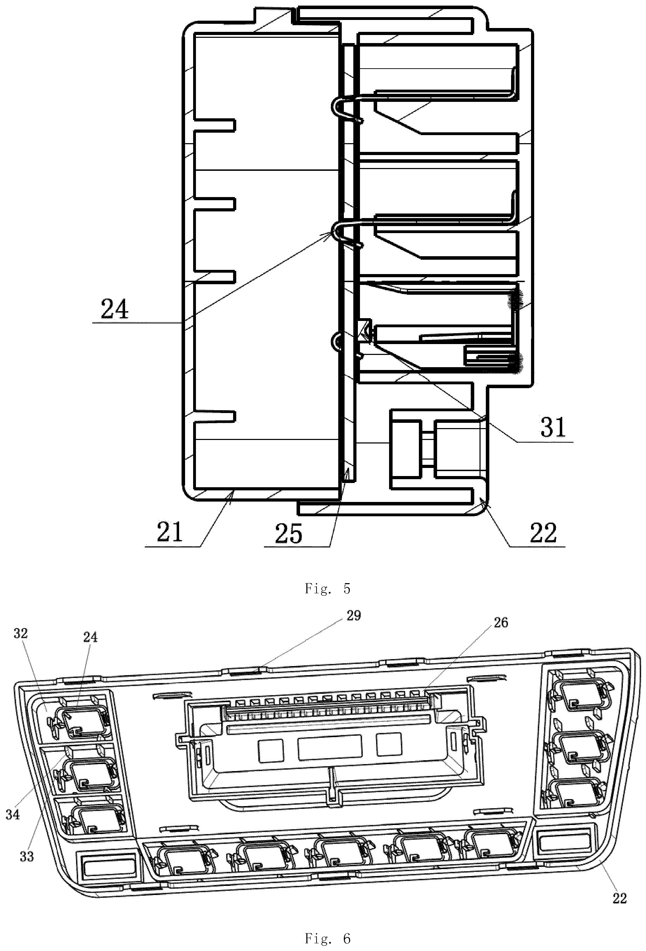

Fig. 3 generally shows a control panel according to an embodiment of the present invention, taking a center console in a motor vehicle as an example, the control panel includes a capacitive touch assembly according to an embodiment of the present invention. The control panel mainly comprises a back frame 21, a printed circuit board assembly 25, a display module 26, an elastic conductor 24, a cover plate 22, and a display cover plate 27. The back frame 21 is provided with a fixing part 30 thereon, and the printed circuit board assembly 25 is fixed to the fixing part 30 of the back frame 21 through a connection means such as a screw. The printed circuit board assembly 25 is provided with necessary electronic components including an indicator light 31 (see Fig. 5), for example an LED lamp, and a display module 26 (for example, an LCD module), the indicator 31 serves as a backlight for illuminating the touch key 23, and accordingly, an opening region for exposing the display module 26 is provided on the cover plate 22. A locking protrusion 28 is provided on the back frame 21, and a locking groove 29 is provided on the cover plate 22. The cover plate 22 and the back frame 21 are fixed by the combination of the locking protrusion 28 and the locking groove 29, and the aforementioned components including such as the printed circuit board assembly 25 and the display module 26 are accommodated therebetween. The display cover plate 27 can cover the position corresponding to the display module 26, that is, cover the opening region. A plurality of touch keys are provided on the cover plate 22 other than the opening region,, and the touch key 23 may include an indication pattern formed by a light-transmissive region, such as an indicating sign. Fig. 4 shows the control panel of the center console more clearly. It can be seen from the figure that the cover plate 22 is provided with a plurality of touch keys 23, including an air volume increasing key, an air volume decreasing key, a temperature increasing key, a temperature decreasing key, a direction control key, and so on for an air-conditioner.

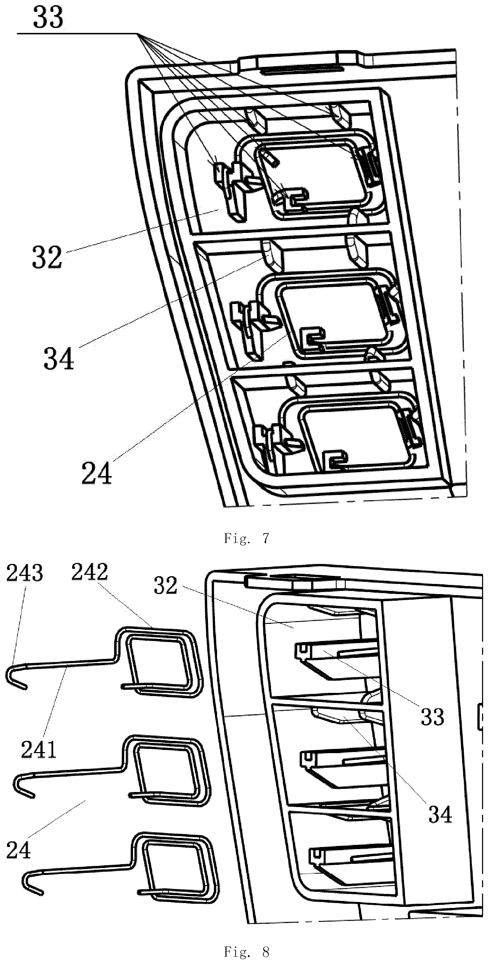

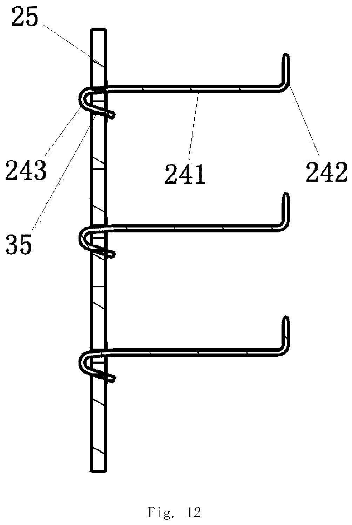

Fig. 5 is a cross sectional view of the control panel taken along line A-A in Fig. 4. It can be seen from Fig. 5 that the elastic conductor 24 is installed in the capacitive touch assembly. As for the connection of the elastic conductor 24 to the cover plate 22 and the printed circuit board assembly 25, it will be described below in more detail with reference to Figs. 6-12. Firstly, the structure of the elastic conductor 24 is described with reference to Fig. 8, the elastic conductor 24 is made of a metal material. The elastic conductor 24 includes a helical section 242, a bending section 243, and an extension section 241 between the helical section 242 and the bending section 243. The helical section 242 comprises one end of the elastic conductor 24, said end of the elastic conductor 24 is configured to tilt toward the bending section 243, and a portion of the helical section 242 excluding said end is constructed to be in the same plane. The portion of the helical section 242 excluding said end has a substantially quadrilateral profile. The bending section 243 comprises a fishhook-like structure. The helical section 242 and the bending section 243 are respectively located at two ends of the elastic conductor 24, and the extension section 241 is between the helical section 242 and the bending section 243. By forming a helical section 242 at one end of the elastic conductor 24, the elasticity of the elastic conductor 24 can be increased. Similarly, by forming a bending section 243 of a fishhook-like structure at one end of the elastic conductor 24, it will also generate elasticity in the elastic conductor 24.

A mounting groove 32 is provided at a side of the cover plate 22 opposite to the touch key 23 and at a position corresponding to the touch key 23, for receiving the helical section 242 of the elastic conductor 24. A retaining rib 33 is provided in the mounting groove 32 for positioning and retaining the elastic conductor 24. As shown in Fig. 6, the number of the mounting groove 32 is the same as the number of the touch keys 23, and is the same as the number of the elastic conductors 24. In each mounting groove 32, there are a plurality of retaining ribs 33, as shown in Fig. 7, including a first guide retaining rib for guiding the end of the helical section 242 of the elastic conductor 24 that tilts toward the bending section 243, a clamping retaining rib for clamping the helical portion of the helical section 242, and a second guide retaining rib for guiding the extension section 241 of the elastic conductor 24. Each retaining rib is provided with a groove for guiding or clamping corresponding portions of the elastic conductor. A distance between inner walls of the groove of each of the first guide retaining rib and the second guide retaining rib is greater than the diameter of the elastic conductor, and a distance between inner walls of the groove of the clamping retaining rib is smaller than the diameter of the elastic conductor, so that the elastic conductor can be tightly fixed. Advantageously, a positioning boss may be provided at the bottom of the mounting groove 32, and the positioning boss has a quadrilateral profile that is smaller than a quadrilateral profile of the helical section 242, so that the helical section 242 can be mounted around the positioning boss. Preferably, a reinforcing rib 34 is provided in the mounting groove 32 to enhance the strength of the mounting groove 32.

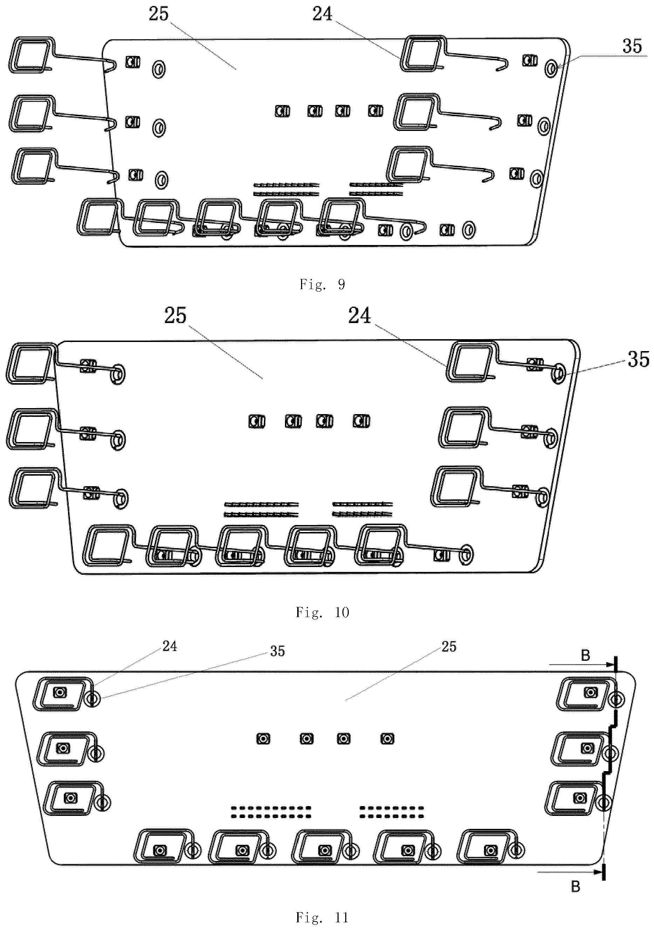

As shown in Figs. 9-12, the printed circuit board assembly 25 comprises a contact hole 35 extending through the printed circuit board assembly 25, and the fishhook-like structure is inserted into the contact hole 35, and the contact hole 35 is coated with a conductive layer (for example, a gold or tin material), for example, gold is coated on a copper sheet. The elastic conductor 24 is configured to be electrically connected to the printed circuit board assembly 25 through the contact hole 35.

It should be noted that the elastic conductor 24 is maintained between the cover plate 22 and the printed circuit board assembly 25 in a pre-compressed manner. As shown in Fig. 5, the helical section 242 of the elastic conductor 24 is inserted into the mounting groove 32 of the cover plate 22 and clamped by the retaining ribs. As shown in Figs. 6-7, the bending section 243 of the elastic conductor 24 is inserted into the contact hole 35 of the printed circuit board assembly 25, wherein the diameter of the contact hole 35 is smaller than the maximum diameter of the fishhook-like structure of the bending section 243, so that the bending section 243 may rest against the contact hole 35 when the bending section 243 is inserted into the contact hole 35.

According to a further improvement of the present invention, the capacitive touch assembly of the present invention may include a limiting disk in which a plurality of through holes are provided, the number of through holes is equal to the number of elastic conductors 24, and the limiting disk is made of an insulation material. The plurality of elastic conductors 24 can pass through the through holes of the limiting disk, and the plurality of elastic guides 24 can be combined together by the limiting disk, thereby enhancing their stability. Advantageously, a metal sheet is attached to the helical section 242 of the elastic conductor 24 by conductive glue, the metal sheet is quadrilateral in shape and has an area slightly greater than that of the quadrangular profile of the helical section 242.

According to the capacitive touch assembly of the present invention, an elastic conductor is disposed between a cover plate or a cover sheet and a printed circuit board assembly, without any foils, so as to realize a capacitive touch sensing function. The elastic conductor can convert a mechanical touch signal into an electrical signal and transmit it to the printed circuit board assembly, thereby avoiding the need for integrating wires to the foil and the need for connecting the foil to the cover plate by gluing, and significantly reducing material costs and process costs. In addition, since the attachment process of the panel film and the foil is no longer required in the manufacturing process, the process is simple.

Advantageously, the elastic conductor is maintained between the cover plate and the printed circuit board assembly in a pre-compressed manner, which makes the elastic conductor and the printed circuit board assembly are electrically connected with each other at all times, thereby providing sufficient contact reliability. In the present invention, the elastic conductor is configured as a structure with a foot and a crown, specifically, the elastic conductor includes a bending section and a helical section. Through the design of hook-shaped structure of the bending section and a contact hole, the tolerance of manufacturing the elastic conductor may be relaxed. In this case, the elastic conductor can be easily held between the cover plate and the printed circuit board assembly with a certain pre-compression, and sufficient contact between the elastic conductor and the printed circuit board assembly can be ensured. The design of circular helical section expands the contact area and facilitates the transmission of the mechanical touch signal.

Due to the pre-compression of the elastic conductor acting on the cover plate, the user feels a better tactile impression when manipulating touch keys. Further, the same effect as the physical press key can be provided on the touch-sensitive switch, that is, the touch-sensitive switch can be operated in a touch manner, and it can also be pushed down slightly like the physical press key, and by means of elastic restoring force provided by the elastic conductor, it makes the user feel like pressing the physical press key.

In addition, in the capacitive touch assembly of the present invention, the elastic conductor is installed in a mounting groove on a back side of the cover plate, and the elastic conductor is guided, positioned and fixed by a retaining rib in the mounting groove, and the structure of the retaining rib and the structure of the helical section are matched in shape with each other, so that the elastic conductor is firmly mounted and the elastic conductor will not be loosened at any time. The design of the mounting groove and the retaining rib guarantees flatness of a side of the cover plate facing the user, because the pre-compression of the elastic conductor is distributed dispersedly on the retaining rib, and the area of the touch key of the cover plate does not receive excessive force accordingly.

In summary, the capacitive touch assembly and the control panel including the same according to the present invention have better technical effects.

While the embodiments of the present invention have been shown and described, variations and modifications may be made to these embodiments by those skilled in the art. The scope of the present invention is defined by the appended claims.

### Reference numeral list

11 panel
12 foil
13 printed circuit board
14 press key
15 flexible printed circuit
16 connector
17 touch action
18 electrical signal
21 back frame
22 cover plate
23 touch key
24 elastic conductor
25 printed circuit board assembly
26 display module
27 display cover plate
28 locking protrusion
29 locking groove
30 fixing part
31 indicator
32 mounting groove
33 retaining rib
34 reinforcing rib
35 contact hole
241 extension section
242 helical section
243 bending section

## Claims

1. A capacitive touch assembly, comprising a cover plate (22) and a printed circuit board assembly (25), wherein the capacitive touch assembly further comprises a conductor located between the cover plate (22) and the printed circuit board assembly (25) and electrically connected to the printed circuit board assembly (25), wherein the conductor is an elastic conductor (24), wherein the elastic conductor (24) comprises a helical section (242), a bending section (243) and an extension section (241) between the helical section (242) and the bending section (243), **characterized in that** the cover plate (22) comprises a touch key (23), and a mounting groove (32) being provided at a side of the cover plate (22) opposite to the touch key (23) and at a position corresponding to the touch key (23), and configured to receive the helical section (242) of the elastic conductor (24), wherein a retaining rib (33) is provided in the mounting groove (32) configured to position and retain the elastic conductor (24).

2. The capacitive touch assembly according to claim 1, wherein the elastic conductor (24) is maintained between the cover plate (22) and the printed circuit board assembly (25) in a pre-compressed manner.

3. The capacitive touch assembly according to claim 1, wherein the helical section (242) comprises one end of the elastic conductor (24), said end of the elastic conductor (24) is configured to tilt toward the bending section (243), and a portion of the helical section (242) excluding said end is constructed to be in a same plane.

4. The capacitive touch assembly according to claim 3, wherein the portion of the helical section (242) excluding said end has a substantially quadrilateral profile.

5. The capacitive touch assembly according to claim 1, wherein the bending section (243) comprises a fishhook-like structure.

6. The capacitive touch assembly according to claim 5, wherein the printed circuit board assembly (25) comprises a contact hole (35) extending through the printed circuit board assembly (25), the fishhook-like structure of the bending section (243) being inserted into the contact hole 35.

7. The capacitive touch assembly according to claim 6, wherein the contact hole (35) is coated with a conductive layer.

8. The capacitive touch assembly according to claim 1, wherein a reinforcing rib (34) is provided in the mounting groove (32).

9. The capacitive touch assembly according to claim 1, wherein an indicator (31) is provided on the printed circuit board assembly (25), and the touch key (23) comprises an indicating pattern formed of a light transmitting region.

10. A control panel, comprising the capacitive touch assembly according to any one of claims 1-9.

11. The control panel according to claim 10, further comprising a display module (26).

## Patentansprüche

1. Kapazitive Berührungsanordnung, die eine Abdeckplatte (22) und eine Leiterplattenanordnung (25) umfasst, wobei die kapazitive Berührungsanordnung ferner einen Leiter umfasst, der sich zwischen der Abdeckplatte (22) und der Leiterplattenanordnung (25) befindet und elektrisch mit der Leiterplattenanordnung (25) verbunden ist, wobei der Leiter ein elastischer Leiter (24) ist, wobei der elastische Leiter (24) einen spiralförmigen Abschnitt (242), einen Biegeabschnitt (243) und einen Verlängerungsabschnitt (241) zwischen dem spiralförmigen Abschnitt (242) und dem Biegeabschnitt (243) umfasst, **dadurch gekennzeichnet, dass** die Abdeckplatte (22) eine Berührungstaste (23) und eine Montagenut (32) umfasst, die an einer der Berührungstaste (23) gegenüberliegenden Seite der Abdeckplatte (22) und an einer der Berührungstaste (23) entsprechenden Position vorgesehen und dazu ausgelegt ist, den spiralförmigen Abschnitt (242) des elastischen Leiters (24) aufzunehmen, wobei eine Halterippe (33) in der Montagenut (32) vorgesehen und dazu ausgelegt ist, den elastischen Leiter (24) zu positionieren und zu halten.

2. Kapazitive Berührungsanordnung gemäß Anspruch 1, wobei der elastische Leiter (24) zwischen der Abdeckplatte (22) und der Leiterplattenanordnung (25) vorkomprimiert gehalten wird.

3. Kapazitive Berührungsanordnung gemäß Anspruch 1, wobei der spiralförmige Abschnitt (242) ein Ende des elastischen Leiters (24) umfasst, wobei das Ende des elastischen Leiters (24) dazu ausgelegt ist, sich in Richtung des Biegeabschnitts (243) zu neigen, und wobei ein Bereich des spiralförmigen Abschnitts (242) mit Ausnahme des Endes so ausgelegt ist, dass er sich in einer gleichen Ebene befindet.

4. Kapazitive Berührungsanordnung gemäß Anspruch 3, wobei der Bereich des spiralförmigen Abschnitts (242) mit Ausnahme des Endes ein im Wesentlichen viereckiges Profil aufweist.

5. Kapazitive Berührungsanordnung gemäß Anspruch 1, wobei der Biegeabschnitt (243) eine fischhakenartige Struktur umfasst.

6. Kapazitive Berührungsanordnung gemäß Anspruch 5, wobei die Leiterplattenanordnung (25) ein Kontaktloch (35) umfasst, das sich durch die Leiterplattenanordnung (25) erstreckt, wobei die fischhakenartige Struktur des Biegeabschnitts (243) in das Kontaktloch (35) eingesetzt ist.

7. Kapazitive Berührungsanordnung gemäß Anspruch 6, wobei das Kontaktloch (35) mit einer leitenden Schicht beschichtet ist.

8. Kapazitive Berührungsanordnung gemäß Anspruch 1, wobei in der Montagenut (32) eine Verstärkungsrippe (34) vorgesehen ist.

9. Kapazitive Berührungsanordnung gemäß Anspruch 1, wobei eine Anzeige (31) auf der Leiterplattenanordnung (25) vorgesehen ist und die Berührungstaste (23) ein Anzeigemuster umfasst, das aus einem lichtdurchlässigen Bereich gebildet ist.

10. Bedienfeld, umfassend die kapazitive Berührungsanordnung gemäß einem der Ansprüche 1-9.

11. Bedienfeld gemäß Anspruch 10, ferner umfassend ein Anzeigemodul (26).

## Revendications

1. Ensemble tactile capacitif, comportant une plaque (22) de couverture et un ensemble (25) de carte à circuit imprimé, l'ensemble tactile capacitif comportant en outre un conducteur situé entre la plaque (22) de couverture et l'ensemble (25) de carte à circuit imprimé et relié électriquement à l'ensemble (25) de carte à circuit imprimé, le conducteur étant un conducteur élastique (24), le conducteur élastique (24) comportant une section hélicoïdale (242), une section coudée (243) et une section (241) de prolongement entre la section hélicoïdale (242) et la section coudée (243), **caractérisé en ce que** la plaque (22) de couverture comporte une touche tactile (23), et **en ce qu'**un alvéole (32) de montage est ménagé d'un côté de la plaque (22) de couverture opposé à la touche tactile (23) et dans une position correspondant à la touche tactile (23), et configuré pour recevoir la section hélicoïdale (242) du conducteur élastique (24), une nervure (33) de retenue étant réalisée dans l'alvéole (32) de montage et configurée pour positionner et retenir le conducteur élastique (24).

2. Ensemble tactile capacitif selon la revendication 1, le conducteur élastique (24) étant maintenu entre la plaque (22) de couverture et l'ensemble (25) de carte à circuit imprimé de manière pré-comprimée.

3. Ensemble tactile capacitif selon la revendication 1, la section hélicoïdale (242) comportant une extrémité du conducteur élastique (24), ladite extrémité du conducteur élastique (24) étant configurée pour basculer vers la section coudée (243), et une partie de la section hélicoïdale (242) à l'exclusion de ladite extrémité étant construite pour se trouver dans un même plan.

4. Ensemble tactile capacitif selon la revendication 3, la partie de la section hélicoïdale (242) à l'exclusion de ladite extrémité présentant un profil sensiblement quadrilatéral.

5. Ensemble tactile capacitif selon la revendication 1, la section coudée (243) comportant une structure en hameçon.

6. Ensemble tactile capacitif selon la revendication 5, l'ensemble (25) de carte à circuit imprimé comportant un trou (35) de contact s'étendant à travers l'ensemble (25) de carte à circuit imprimé, la structure en hameçon de la section coudée (243) étant insérée dans le trou (35) de contact.

7. Ensemble tactile capacitif selon la revendication 6, le trou (35) de contact étant revêtu d'une couche conductrice.

8. Ensemble tactile capacitif selon la revendication 1, une nervure (34) de renfort étant réalisée dans l'alvéole (32) de montage.

9. Ensemble tactile capacitif selon la revendication 1, un indicateur (31) étant placé sur l'ensemble (25) de carte à circuit imprimé, et la touche tactile (23) comportant un motif d'indication formé d'une région transmettant la lumière.

10. Panneau de commande, comportant l'ensemble tactile capacitif selon l'une quelconque des revendications 1 à 9.

11. Panneau de commande selon la revendication 10, comportant en outre un module (26) d'affichage.
